# EUROPÄISCHE PATENTSCHRIFT

(11) **EP 0 482 425 B1**
(45) Veröffentlichungstag und Bekanntmachung des Hinweises auf die Patenterteilung: **13.09.1995**
(21) Anmeldenummer: 91117196.5
(22) Anmeldetag: 09.10.1991
(51) Int. Cl.: G01R 1/22

(54) **Gerät zur Messung von Strom, vorzugsweise von Strom und Spannung, an Leitern eines ein- oder mehrphasigen Systems**
Device for measuring current, especially current and voltage, on conductors of a single or multiphase system
Dispositif pour mesurer le courant, particulièrement de courant et la tension, d'un système de conducteurs à phase singulière ou multiple

(30) Priorität: 20.10.1990 DE 9014565 U
(43) Veröffentlichungstag der Anmeldung: 29.04.1992
(73) Patentinhaber: KARL PFISTERER ELEKTROTECHNISCHE SPEZIALARTIKEL GMBH & CO. KG, 70324 Stuttgart (DE)
(72) Erfinder: Kuhn, Siegfried, Dipl.-Ing., W-7526 Ubstadt-Weiher 4 (DE); Schächterle, Werner, W-7057 Winnenden (DE)
(74) Vertreter: Patentanwälte Bartels und Partner

(56) Entgegenhaltungen:
- DE-A- 1 905 468
- DE-A- 2 249 278
- FR-A- 1 563 573
- FR-A- 2 044 648
- FR-A- 2 170 303
- FR-A- 2 538 555
- FR-A- 2 538 556
- FR-A- 2 599 848
- US-A- 4 806 855

## Beschreibung

Die Erfindung betrifft ein Gerät zur Messung von Strom, vorzugsweise von Strom und Spannung, an Leitern eines ein- oder mehrphasigen Systems, insbesondere Leitern von Niederspannungs-Energieversorgungsanlagen, welches Gerät die Merkmale des Oberbegriffes des Anspruches 1 aufweist.

Bei einem bekannten Gerät (DE-A-3 707 707) zur Messung von Strom und Spannung an Sammelschienen hat das Gehäuse eine U-artige Form. In den freien Endflächen der beiden Schenkel des Gerätegehäuses mündet je ein geradliniger Kanal für die Aufnahme je eines der beiden Schenkel einer U-förmigen Luftspule. Das Gerätegehäuse umfaßt zusammen mit dieser Luftspule die Sammelschiene, deren Spannung und Stromfluß gemessen werden soll. Eine im Jochteil des Gerätegehäuses angeordnete Brücke aus magnetisch leitendem Metall verbindet die beiden Enden der Luftspule. Eine im Gerätegehäuse angeordnete Elektrode ist an die Sammelschiene kapaziv angekoppelt, wenn das Gerätegehäuse auf die Sammelschiene aufgesetzt ist, und dient als Spannungsensor. Zwar kann ein derartiges Gerät auch zur Messung von Strom und Spannung an anderen Leitern als Sammelschienen, insbesondere auch an Kabeln, eingesetzt werden. Sowohl die Handhabung als auch die erzielbare Meßgenauigkeit sind jedoch dann nicht immer zufriedenstellend.

Bei einem bekannten Gerät der eingangs genannten Art (DE-A-1 905 468) ist der erste Teil der Luftspule auf einem formstabilen Wicklungsträger angeordnet, der eine C-artige Form mit geradlinigem Jochabschnitt und geradlinigen, im Vergleich zum Jochabschnitt kürzeren Schenkeln hat, wovon der eine fest mit dem Gerätegehäuse verbunden ist. Der zweite Teil der Luftspule wird von einem formstabilen Wicklungsträger, der aus einem geradlinigen Stab besteht, getragen, der im Bereich seines einen Endes derart schwenkbar mit dem Gerätegehäuse verbunden ist, daß er in seiner einen Position an den Enden der Schenkel des ersten Wicklungsträgers anliegt und diesen zu einem geschlossenen Rechteck ergänzt, und in seiner anderen Schwenklage den vom anderen Wicklungsträger gebildeten Haken offenhält. Auch die Handhabung dieses Gerätes und damit seine Einsatzmöglichkeiten lassen Wünsche offen. Beispielsweise werden für die beiden Schenkel sowie den Jochteil des ersten Wicklungsträgers Teilspulen benötigt, die in den Eckbereichen Abschirmungen erforderlich machen. Außerdem muß der zweite Wicklungsträger, um das Gerät an einen Leiter ansetzen zu können, vom freien Ende des ersten Wicklungsträgers manuell weggeschwenkt werden, was nicht mit der das Gerätegehäuse festhaltenden Hand möglich ist. Weiterhin ist nachteilig, daß der Schwenkwinkel des ersten Wicklungsträgers groß gewählt werden muß, wenn an einem Leiter mit entsprechend großem Durchmesser eine Messung durchgeführt werden soll.

Der Erfindung liegt daher die Aufgabe zugrunde, ein Gerät der eingangs genannten Art zu schaffen, das beim Gebrauch besser als die bekannten Geräte zu handhaben ist und deshalb sowie wegen einer hohen Meßgenauigkeit vielfältige Einsatzmöglichkeiten eröffnet. Diese Aufgabe löst ein Gerät mit den Merkmalen des Anspruches 1.

Dadurch, daß von den beiden Gehäusen, welche den ersten bzw. zweiten Abschnitt der Luftspüle enthalten, wenigstens das eine drehbar um die Längsachse des von ihm gebildeten Schenkels des U-artigen Bügels im Gerätegehäuse gelagert ist, läßt sich das erfindungsgemäße Gerät an Leiter beliebiger Ausführung, also beispielsweise auch an ein Kabel, bequem ansetzen und auch wieder von diesem Leiter abnehmen. Dazu braucht nämlich nur der relativ zum Gerätegehäuse bewegliche Teil der Luftspule vorüber gehend aus derjenigen Lage, in der er sich an den ersten Abschnitt anschließt und der von letzterem gebildete Haken zu einem U-artigen Bügel ergänzt ist, in eine Lage gebracht zu werden, in welcher der Haken zum Einführen des Leiters offen ist. Selbstverständlich kann das Gerät auch so ausgebildet sein, daß normalerweise der vom ersten Abschnitt der Luftspule gebildete Haken offen ist und daß er nur während der Messung durch den zweiten Abschnitt zu dem U-artigen Bügel ergänzt ist. Die einfache Handhabungsweise des erfindungsgemäßen Gerätes ermöglicht es sogar, das Gerät mit nur einer Hand zu handhaben. Es eignet sich daher in besonderm Maß für Messungen an Kabeln und Stromschienen in Niederspannungsverteilungen, z.B. Kabelverteilerschränken, Hausanschlußkästen und Stromverteilungen, aber auch an Betriebsmitteln wie Transformatoren, Motoren oder Generatoren. Weil für die Handhabung nur das isolierte Gerätegehäuse mit der Hand berührt wird, läßt sich das Gerät unter Spannung an den zu messenden Leiter ansetzen und von ihm abnehmen.

Da die Luftspule nicht über eine Brücke aus magnetisch leitendem Material, also ferromagnetischem Material, geschlossen wird, sondern dadurch, daß die Enden ihrer Abschnitte in eine Lage gebracht werden, in der sie aneinander anschließen, ergibt sich für die Strommessung die gewünschte Meßgenauigkeit, und zwar unabhängig von der Lage der Spule relativ zum Leiter, da die Luftspule einlagig oder zweilagig ist, die aktive Fläche jeder Windung gleich ist, die Steigung der Windungen zumindest nahezu konstant ist und die Windungszahl mehr als 400 beträgt.

Als Spannungsensor kann im Gerätegehäuse eine Elektrode vorgesehen sein, welche kapazitiv an den Leiter angekoppelt wird. Bei einer bevorzugten Ausführungsform ist jedoch eine an den Leiter ansetzbare Klemme vorgesehen, welche über ein flexibles Kabel mit der im Gerätegehäuse enthaltenen Signalverarbeitungselektronik verbunden ist.

Es wäre zwar möglich, die im Gerätegehäuse liegenden Enden des ersten und zweiten Abschnittes der Luftspule aneinander anschließen zu lassen. Im Hinblick auf die Bewegbarkeit wenigstens eines Abschnittes der Luftspule relativ zum Gehäuse, ist es allerdings in vielen Fällen zweckmäßiger, zwischen den im Gerätegehäuse liegenden Enden des ersten und zweiten Abschnittes der Luftspule den dritten Abschnitt der Luftspule vorzusehen.

Vorzugsweise sind die beiden den ersten bzw. zweiten Abschnitt der Luftspule enthaltenen Gehäuse gleich ausgebildet, so daß sie je eine Hälfte des U-artigen Bügels bilden.

Sofern der Jochabschnitt des U-artigen Bügels die Form eines Halbkreises hat, paßt sich die Luftspule sehr gut an ein Kabel an.

Um bequem den zweiten Abschnitt der Luftspule und, falls auch der erste Abschnitt beweglich ist, diesen, für das Ansetzen des Gerätes an einen Leiter und das Abnehmen betätigen zu können, ist bei einer bevorzugten Ausführungsform ein außerhalb des Gerätegehäuses liegendes, manuell betätigbares Antriebsglied vorgesehen, das beispielsweise die Form eines Druckknopfes oder Schiebers haben kann. Um einen nur in einer Richtung wirksamen, manuellen Antrieb zu benötigen, ist vorzugsweise wenigstens eine vorgespannte Feder vorgesehen, welche den beweglichen Abschnitt oder die beweglichen Abschnitte in einer der beiden Endstellungen zu halten sucht. Hält die Feder beispielsweise den beweglichen Abschnitt oder die beweglichen Abschnitte in der einen geschlossenen Bügel ergebenden Lage, dann braucht das Antriebsglied nur entgegen der Kraft der Rückholfeder bewegt zu werden, um den Bügel zu öffnen.

Die Signalverarbeitungselektronik weist vorzugsweise außer ihren Ausgängen für Strom und Spannung einen Ausgang für ein Signal auf, das die Leistung, vorzugsweise die Wirkleistung, repräsentiert. Bei einer bevorzugten Ausführungform liefert die Signalverarbeitungselektronik die Ausgangssignale in Form von eingeprägten Strömen. Selbstverständlich wäre aber auch eine Ausgabe der Meßwerte in digitaler Form möglich.

Die von der Signalverarbeitungselektronik gelieferten Ausgangssignale können über eine Verbindungsleitung einem Gerät zugeführt werden, das die gemessenen Werte anzeigt und/oder ausdruckt. Selbstverständlich ist es aber auch möglich, das erfindungsgemäße Gerät mit einer Anzeigeeinrichtung, insbesondere in Form eines Displays, auszurüsten.

Im folgenden ist die Erfindung an Hand eines in der Zeichnung dargestellten Ausführungsbeispiels im einzelnen erläutert.

Es zeigen
- Fig. 1: eine Ansicht des Ausführungsbeispiels,
- Fig. 2: einen Längsschnitt des Ausführungsbeispiels.
- Fig. 3: eine perspektivisch dargestellte Ansicht des Ausführungsbeispiels, wobei der Bügel mit ausgezogenen Linien im geöffneten Zustand und mit strichpunktierten Linien im geschlossenen Zustand wiedergegeben ist.

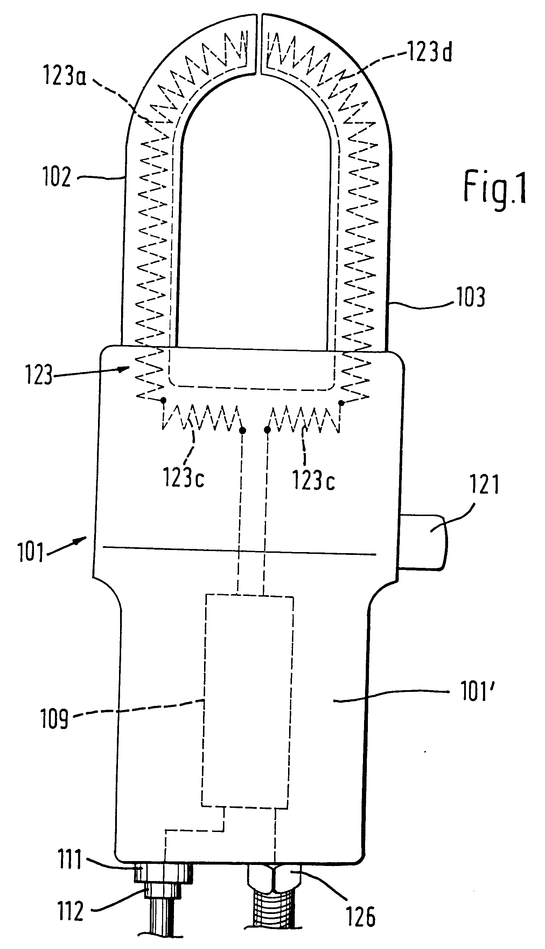

Das in den Fig. 1 bis 3 dargestellte Ausführungsbeispiel des erfindungsgemäßen Gerätes weist ein Gerätegehäuse 101 aus Kunststoff auf, das insofern von einer Quaderform abweicht, als der als Griff dienende Teil 101′ eine geringere Breite hat als der übrige Teil, der außerdem im Ausführungsbeispiel gegenüber dem Griffteil 101′ abgewinkelt ist. Diese Abwinklung ermöglicht es, den Griffteil 101′ in eine Lage etwa parallel zu dem zu messenden Leiter zu bringen, was beispielsweise bei einer Messung in einem Kabelverteilerschrank sehr vorteilhaft ist. Über die dem Griffteil 101′ abgewandte Stirnseite des breiteren Teils des Gerätegehäuses 101 stehen zwei formstabile Spulengehäuse 102 und 103 über, die je einen geradlinigen Abschnitt und einen sich an diesen anschließenden gekrümmten Abschnitt in Form eines Viertelkreises aufweisen. Die beiden geradlinigen Abschnitte sind parallel zueinander so angeordnet, daß zwischen den freien Endflächen ihrer gekrümmten Abschnitte kein Luftspalt oder allenfalls ein geringer Luftspalt vorhanden ist, wenn diese gekrümmten Abschnitte gegeneinander weisen und zusammen mit den geradlinigen Abschnitten einen U-förmigen Bügel mit halbkreisförmigem Jochabschnitt bilden. Die beiden gleich ausgebildeten Spulengehäuse 102 und 103 sind ebenso wie das Gerätegehäuse 101 je aus zwei aus Kunststoff bestehenden Halbschalen zusammengesetzt.

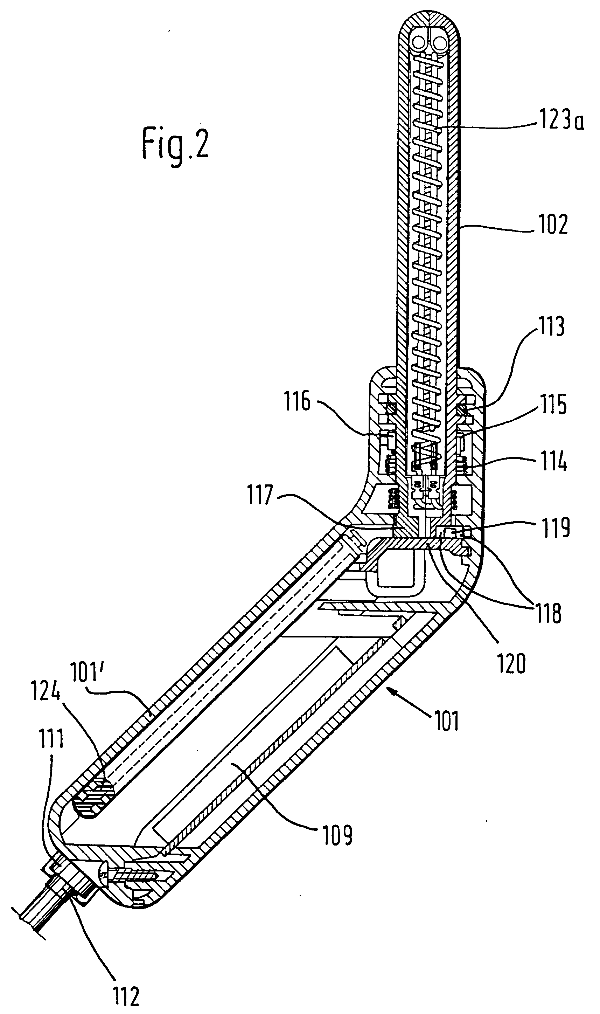

Wie Fig. 2 zeigt, sind die im Inneren des Gerätegehäuses 101 liegenden Endabschnitte der beiden Spulengehäuse 102 und 103 um ihre Längsachse drehbar, aber in axialer Richtung unverschiebbar, im Gerätegehäuse 101 gelagert. Je ein 0-Ring 113 sorgt für eine Dichtung zwischen dem Spulengehäuse und dem Gerätegehäuse 101. Je eine vorgespannte Feder 114, welche jedes Spulengehäuse 102 und 103 in dessen im Gerätegehäuse 101 gelagerten Endabschnitt umgibt, ist einerseits am Gerätegehäuse 101 und andererseits an einem radialen Vorsprung 115 des Spulengehäuses abgestützt. Diese vorgespannten Federn 114 suchen beide Spulengehäuse 102 und 103 in der in Fig. 1 dargestellten Drehlage zu halten, in welcher der U-förmige Bügel geschlossen ist. In dieser Drehlage findet ein zusätzlicher Vorsprung 116 Anschlag an einer Materialpartie des Gerätegehäuses 101.

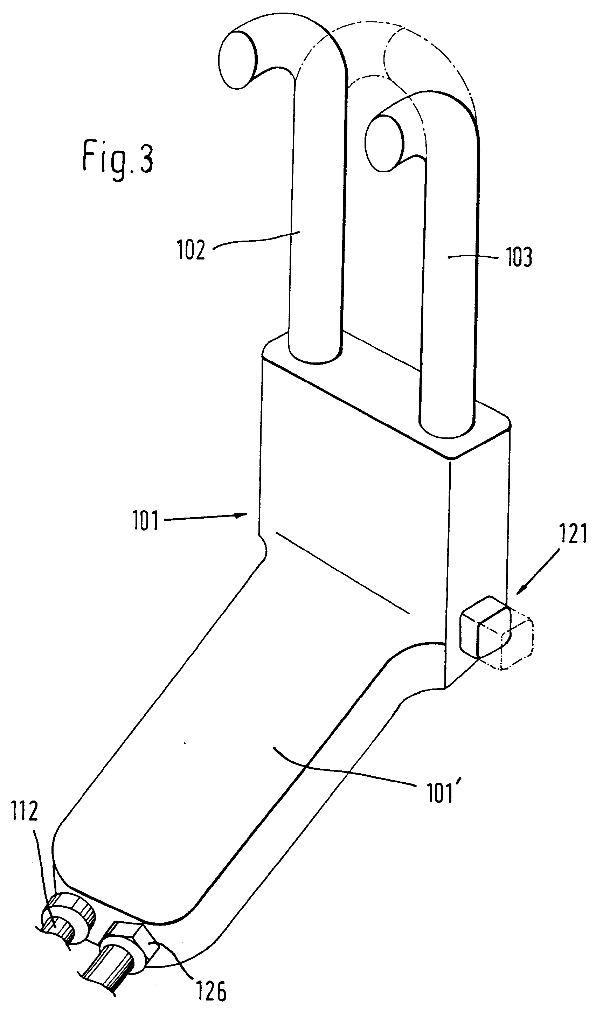

Das im Gerätegehäuse 101 liegende Ende jedes der beiden Spulengehäuse 102 und 103 trägt eine Scheibe 117 mit einem radialen Schlitz 118, in den ein Zapfen 119 eingreift. In derjenigen Drehlage, in welcher der Bügel geschlossen ist, erstrecken die beiden radialen Schlitze 118 in entgegengesetzte Richtungen. Die beiden Zapfen 119 stehen von einem im Gerätegehäuse 101 in Querrichtung verschiebbar gelagerten Schieber 120 ab, der an seinem einen Ende einen aus dem Gerätegehäuse 101 seitlich im Bereich des breiteren Abschnittes herausragenden Druckknopf 121 bildet. Wenn dieser Druckknopf 121 entgegen der Kraft der Federn 114 in das Gerätegehäuse 101 hineingedrückt wird, wird die translatorische Bewegung des Schiebers 120 in zwei gegensinnige Drehbewegungen der beiden Spulengehäuse 102 und 103 umgesetzt, wodurch diese in die in Fig. 3 mit ausgezogenen Linien dargestellte Lage gedreht werden, in der ihre beiden viertelkreisförmigen Abschnitte in zu einander parallelen Ebenen liegen. In dieser Stellung kann bequem ein elektrischer Leiter eingeführt werden. Wird dann der Druckknopf 121 wieder freigegeben, dann drehen die Feder 114 die beiden Spulengehäuse 102 und 103 wieder in ihre Ausgangslage, die in Fig. 3 mit strichpunktierten Linien dargestellt ist.

Jedes Spulengehäuse 102 und 103 enthält einen Spulenträger aus Kunststoff, auf den ein erster Abschnitt 123a bzw. ein zweiter Abschnitt 123d derart einlagig gewickelt ist, daß die aktive Fläche jeder Windung gleich ist und die Steigung der Windungen zumindest nahezu konstant ist. Die beiden gleich ausgebildeten Abschnitt 123a und 123d sind Teile einer Luftspule 123, die mehr als 400 Windungen aufweist. Wie Fig. 1 zeigt, verläuft von der der freien Stirnfläche des Spulengehäuse benachbarten Windung sowohl des ersten Abschnitts 123a als auch des zweiten Abschnitts 123d der Luftspule 123 eine Verbindungsleitung zurück in das Gerätegehäuse 101 hinein, wo diese beiden Verbindungsleitungen miteinander verbunden sind. Dadurch bildet der zweite Abschnitt 123d bei geschlossenem Bügel eine Fortsetzung des Abschnittes 123a der Luftspule 123 und umgekehrt. Im Gerätegehäuse 101 liegt, auf einem U-förmigen Spulenträger 124 angeordnet, ein dritter Abschnitt 123c der Luftspule 123, der, wie Fig. 1 zeigt, die im Gerätegehäuse 101 liegenden Enden der Abschnitte 123a und 123d zu einer Ringspule schließt. Außerdem führen von diesem dritten Abschnitt 123c zwei Verbindungsleitungen zu einer im Griffteil 101′ auf einer Trägerplatte angeordneten Signalverarbeitungselektronik 109. Diese beiden Verbindungsleitungen sind an den Anfang bzw. das Ende der Luftspule 123 angeschlossen und führen deshalb der Signalverarbeitungselektronik 109 die in der Luftspule 123 induzierte Spannung zu, die ein Maß für die Stromstärke des von der Luftspule 123 umschlungenen Leiters ist.

Selbstverständlich wäre es auch möglich, den dritten Abschnitt 123c der Luftspule 123 im wesentlichen geradlinig auszubilden und, wie in Fig. 1 schematisch dargestellt, zwischen den Enden der beiden Spulengehäuse 102 und 103 anzuordnen.

Zum Zwecke der Weiterleitung der von der Signalverarbeitungselektronik 109 erzeugten Ausgangssignale und der Energiezufuhr zu der Signalverarbeitungselektronik 109, falls das Gerät keine Batterie enthält, ist an der den Spulengehäusen 102 und 103 abgewandten Stirnseite des Gerätegehäuses 101 für ein Verbindungskabel eine Kabeldurchführung 126 vorgesehen. Neben dieser ist eine Sicherheitssteckbuchse 111 angeordnet zur Aufnahme eines Sicherheitssteckers 112, der am einen Ende eines Labormeßkabels 108 angeordnet ist, dessen anderes Ende an eine vollisolierte, als Spannungsabgriff dienende Klemme angeschlossen ist.

Die Signalverarbeitungselektronik 109 liefert, wenn diese Klemme die Spannung des von der Luftspule 123 umfaßten Leiters führt, außer dem Strommeßwert auch den Spannungsmeßwert und die Wirkleistungen in Form von eingeprägten Strömen. Die Meßbereiche liegen wie beim ersten Ausführungsbeispiel für die Spannung im Bereich bis zu 300 Volt, für die Strommessung im Bereich bis zu 630 Ampere und die Wirkleistung im Bereich bis zu 157 kW.

Alle in der vorstehenden Beschreibung erwähnten sowie auch die nur allein aus der Zeichnung entnehmbaren Merkmale sind als weitere Ausgestaltungen Bestandteile der Erfindung, auch wenn sie nicht besonders hervorgehoben und insbesondere in den Ansprüchen erwähnt sind.

## Patentansprüche

1. Gerät zur Messung von Strom, vorzugsweise von Strom und Spannung, an Leitern eines ein- oder mehrphasigen Systems, insbesondere Leitern von Niederspannungs-Energieversorgungsan lagen, mit
a) einem Gerätegehäuse (101),
b) einer zumindest auf einem Teil ihrer Länge sich außerhalb des Gehäuses (101) befindenden Luftspule (123) des Stromsensors, mittels derer der Leiter auf seinem Umfang umfaßbar ist und eine den Leiter enthaltende, in sich geschlossene Ringspule herstellbar ist, wobei die Luftspule (123)
b1) einen vom Gerätegehäuse (101) abstehenden ersten Abschnitt (123a), der eine sich nicht verändernde, zum Gerätegehäuse (101) hin offene hakenähnliche Form hat, sowie
b2) einen zweiten Abschnitt (123d) mit sich ebenfalls nicht verändernder Form aufweist, der in einer Führung des Gerätegehäuses (101) zwischen einer Position, in welcher sein freies Ende sich an dasjenige des ersten Abschnittes (123a) anschließt, sowie einer Position bewegbar geführt ist, in welcher der vom ersten Abschnitt (123a) gebildete Haken offen ist,
c) einer im Gerätegehäuse (101) untergebrachten Signalverarbeitungselektronik (109), welcher die vom Stromsensor erzeugten Signale zugeführt werden,
dadurch gekennzeichnet, daß
d) der zweite Abschnitt (1 23d) in derjenigen Position, in welcher sein freies Ende sich an dasjenige des ersten Abschnittes (123a) anschließt, letzteren zu einem U-artigen Bügel mit sich an das Gerätegehäuse (101) anschließenden Schenkeln ergänzt,
e) im Inneren des Gerätegehäuses (101) ein von ferromagnetischem Material freier dritter Abschnitt (123c) der Luftspule (123) vorgesehen ist, der einerseits an den ersten Abschnitt (123a) der Luftspule (123) und andererseits an deren zweiten Abschnitt (123d) anschließt,
f) von zwei den ersten bzw. zweiten Abschnitt (123a, 123d) der Luftspule (123) enthaltenden Gehäusen (102, 103) wenigstens das eine um die Längsachse des von ihm gebildeten Schenkels des U-artigen Bügels drehbar im Gerätegehäuse (101) gelagert ist.

2. Gerät nach Anspruch 1, dadurch gekennzeichnet, daß beide Gehäuse (102, 103) gleich ausgebildet sind und je eine Hälfte des U-artigen Bügels bilden.

3. Gerät nach Anspruch 1 oder 2, dadurch gekennzeichnet, daß die den ersten und zweiten Abschnitt (123a, 123d) der Luftspule (123) enthaltenden Gehäuse (102, 103) formstabil ausgebildet sind.

4. Gerät nach einem der Ansprüche 1 bis 3, gekennzeichnet durch ein außerhalb des Gerätegehäuses (101) liegendes, manuell betätigbares Antriebsglied (121) für eine Einrichtung zum Bewegen des zweiten (123d) und des gegebenenfalls ebenfalls beweglichen ersten Abschnittes (123a) der Luftspule (123).

5. Gerät nach einem der Ansprüche 1 bis 4, gekennzeichnet durch wenigstens eine vorgespannte Rückstellfeder (114), welche den zweiten Abschnitt (123d) und gegebenenfalls den ebenfalls bewegbaren ersten Abschnitt (123a) der Luftspule in der einen Endstellung zu halten sucht.

6. Gerät nach einem der Ansprüche 1 bis 5, dadurch gekennzeichnet, daß der Spannungssensor eine Klemme aufweist, die an eine aus dem Gerätegehäuse (101) herausgeführte Meßleitung angeschlossen oder anschließbar ist.

7. Gerät nach Anspruch 6, dadurch gekennzeichnet, daß die Klemme vollisoliert ist, die Meßleitung ein isoliertes, flexibles Kabel ist und zur Verbindung der Meßleitung mit der Signalverarbeitungselektronik (109) das Gerätegehäuse (101) mit einer Laborsicherheitssteckbuchse (111) zur Aufnahme eines an der Meßleitung vorgesehenen Sicherheitssteckers (112) versehen ist.

8. Gerät nach einem der Ansprüche 1 bis 7, dadurch gekennzeichnet, daß die Signalverarbeitungselektronik (109) außer ihren Ausgängen für Strom und Spannung einen Ausgang für die aus Strom und Spannung bestimmte Leistung, insbesondere die Wirkleistung, hat.

9. Gerät nach Anspruch 8, dadurch gekennzeichnet, daß die Ausgänge der Signalverarbeitungselektronik (109) Ausgänge für eingeprägte Gleichströme sind.

10. Gerät nach einem der Ansprüche 1 bis 9, dadurch gekennzeichnet, daß das Gerätegehäuse (101) zwei unter einem stumpfen Winkel zueinander angeordnete Abschnitte aufweist, von denen der eine den Griffteil (101′) bildet und der andere den ersten und zweiten Abschnitt (123a, 123d) der Luftspule (123) trägt.

## Claims

1. Equipment for measuring current, preferably current and voltage, in conductors of a single or multi-phase system, particularly conductors of low-voltage energy-supply systems, with
a) an equipment housing (101),
b) an air-core coil (123) of the current sensor, disposed outside the housing (101) for at least part of its length, by means of which the periphery of the conductor can be surrounded and a closed toroidal coil containing the conductor can be formed, the air-core coil (123) having
b1) a first portion (123a) projecting from the equipment housing (101) and having an unchanging hook-like shape open towards the equipment housing (101), and
b2) a second portion (123d), also with an unchanging shape, guided for moving in a guide of the equipment housing (101) between a position in which its free end is adjacent that of the first portion (123a) and a position in which the hook formed by the first portion (123a) is open,
c) signal-processing electronics (109) which are housed in the equipment housing (101) and to which the signal produced by the current sensor is supplied,
characterized in that
d) when the second portion (123d) is in the position in which its free end is adjacent that of the first portion (123a), it complements the latter to form a U-shaped hoop with sides connected to the equipment housing (101),
e) a third portion (123c) of the air-core coil (123), which is free of ferromagnetic material, is provided inside the equipment housing (101) and is connected to the first portion (123a) of the air-core coil (123) on one side and to the second portion (123d) on the other side,
f) of two housings (102, 103) containing the first and second portions (123a, 123d) of the air-core coil (123), respectively, at least one is mounted in the equipment housing (101) for rotating about the longitudinal axis of the side of the U-shaped hoop formed thereby.

2. Equipment according to Claim 1, characterized in that both housings (102, 103) are similarly constructed and each forms one half of the U-shaped hoop.

3. Equipment according to Claim 1 or Claim 2, characterized in that the housings (102, 103) containing the first and second portions (123a, 123d) of the aircore coil (123) are of dimensionally stable construction.

4. Equipment according to any one of Claims 1 to 3, characterized by a manually-operable operating member (121) disposed outside the equipment housing (101) for a device for moving the second (123d) and, if applicable, also the movable first portion (123a) of the air-core coil (123).

5. Equipment according to any one of Claims 1 to 4, characterized by at least one prestressed return spring (114) which seeks to keep the second portion (123d) and, if applicable, also the movable first portion (123a) of the air-core coil in one end position.

6. Equipment according to any one of Claims 1 to 5, characterized in that the voltage sensor comprises a clip which is connected or connectible to an instrument lead led out of the equipment housing (101).

7. Equipment according to Claim 6, characterized in that the clip is fully insulated, the instrument lead is an insulated, flexible cable, and in order to connect the instrument lead to the signal processing electronics (109), the equipment housing (101) is provided with a laboratory safety socket (111) for housing a safety plug provided on the instrument lead.

8. Equipment according to any one of Claims 1 to 7, characterized in that the signal processing electronics (109) have, in addition to their current and voltage outputs, an output for the power defined by current and voltage, particularly the effective power.

9. Equipment according to Claim 8, characterized in that the outputs of the signal processing electronics (109) are outputs for load-independent direct currents.

10. Equipment according to any one of Claims 1 to 9, characterized in that the equipment housing (101) comprises two portions disposed at an obtuse angle to one another, of which one forms the grip portion (101′) and the other carries the first and second portions (123a, 123d) of the air-core coil (123).

## Revendications

1. Appareil de mesure de courant, avantageusement de courant et de tension, dans des conducteurs d'un système monophasé ou polyphasé, notamment des conducteurs d'installations d'alimentation en énergie basse tension, comportant
a) un carter d'appareil (101),
b) une bobine sans fer (123) du détecteur de courant située au moins sur une partie de sa longueur à l'extérieur du carter (101), au moyen de laquelle le conducteur peut être entouré sur son pourtour, et qui peut être réalisée sous la forme d'une bobine annulaire intrinsèquement fermée et contenant le conducteur, cette bobine sans fer (123)
b1) comportant une première partie (123a) faisant saillie du carter d'appareil (101) et ayant une forme non modifiable de crochet ouvert en direction du carter d'appareil (101), et également
b2) une seconde partie (123d) ayant également une forme non modifiable et qui est guidée de façon mobile, dans un guide du carter d'appareil (101), entre une position dans laquelle son extrémité libre est jointe à celle de la première partie (123a), et une position dans laquelle le crochet formé par la première partie (123a) est ouvert,
c) un circuit électronique de traitement de signaux (109) logé dans le carter d'appareil 101 et recevant les signaux produits par le détecteur de courant,
caractérisé en ce que
d) la seconde partie (123d) produit, dans la position où son extrémité libre est jointe à celle de la première partie (123a), un complément de cette partie par les branches jointes au carter d'appareil (101) pour créer un étrier en forme de U,
e) il est prévu à l'intérieur du carter d'appareil (101) une troisième partie (123c) de la bobine sans fer (123), exempte de matériau ferromagnétique et qui est jointe d'une part à la première partie (123a) de la bobine sans fer (123) et d'autre part à la seconde partie (123d),
f) au moins l'un des deux carters (102, 103) contenant la première et la seconde partie (123a, 123d) de la bobine sans fer (123), est monté dans le carter d'appareil (101) de façon à pouvoir tourner autour de l'axe longitudinal de la branche, formée par lui, de l'étrier en forme de U.

2. Appareil selon la revendication 1, caractérisé en ce que les deux carters (102, 103) sont agencés de façon identique et constituent chacun une moitié de l'étrier en forme de U.

3. Appareil selon la revendication 1 ou 2, caractérisé en ce que les carters (102, 103) contenant la première et la seconde partie (123a, 123d) de la bobine sans fer(123) sont agencés avec une forme stable.

4. Appareil selon une des revendications 1 à 3, caractérisé par un organe d'entraînement, situé à l'extérieur du carter d'appareil (101), pouvant être actionné manuellement et assurant l'entraînement d'un dispositif pour déplacer la seconde partie (123d) de la bobine sans fer (123), et de la première partie (123a), le cas échéant également mobile, de ladite bobine (123).

5. Appareil selon une des revendications 1 à 4, caractérisé par un ressort de retenue précontraint (114), qui a tendance à maintenir la seconde partie (123d), et le cas échéant la première partie (123a), également mobile, de la bobine sans fer dans une des positions limites.

6. Appareil selon une des revendications 1 à 5, caractérisé en ce que le détecteur de tension comporte une borne, qui est reliée ou qui peut être reliée à un conducteur de mesure sortant du carter d'appareil (101).

7. Appareil selon la revendication 6, caractérisé en ce que la borne est complètement isolée, le conducteur de mesure est un câble flexible isolé et, pour une liaison du conducteur de mesure avec le circuit électronique de traitement de signaux (109) , le carter d'appareil (101) est pourvu d'une douille pour fiche de sécurité de laboratoire (111) destinée à recevoir une fiche de sécurité (112) prévue sur le conducteur de mesure.

8. Appareil selon une des revendications 1 à 7, caractérisé en ce que le circuit électronique de traitement de signaux (109) comporte, en plus de ses sorties de courant et de tension, une sortie pour la puissance déterminée à partir du courant et de la tension, notamment la puissance active.

9. Appareil selon la revendication 8, caractérisé en ce que les sorties du circuit électronique de traitement de signaux (109) sont des sorties pour des courants continus imprimés.

10. Appareil selon une des revendications 1 à 9, caractérisé en ce que le carter de l'appareil (101) comporte deux parties orientées d'un angle obtus l'une par rapport à l'autre et dont l'une constitue la partie formant poignée (101′) tandis que l'autre porte la première et la seconde partie (123a, 123b) de la bobine sans fer (123).
